(19) Europäisches Patentamt
European Patent Office
Office européen des brevets

(11) **EP 4 471 434 A1**

(12) **EUROPEAN PATENT APPLICATION**

(43) Date of publication:
**04.12.2024 Bulletin 2024/49**

(51) International Patent Classification (IPC):
**G01R 1/067** (2006.01)     **G01R 19/00** (2006.01)
**G01R 15/09** (2006.01)

(21) Application number: **23177017.3**

(22) Date of filing: **02.06.2023**

(52) Cooperative Patent Classification (CPC):
**G01R 1/06766; G01R 1/06788; G01R 19/0015;**
G01R 15/09; G01R 19/0084

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP B.V.**
**5656 AG Eindhoven (NL)**

(72) Inventor: **MEEKS, Daniel**
**5656 AG Eindhoven (NL)**

(74) Representative: **Schmütz, Christian Klaus
Johannes et al
NXP Semiconductors Germany GmbH
Intellectual Property Group
Beiersdorfstr. 12
22529 Hamburg (DE)**

(54) **A VOLTAGE PROBE**

(57)     A voltage probe comprising: an input connector; an output connector; and an offset measurement connector. The voltage probe also includes an integrator, and amplifier and a capacitor. The capacitor has a first plate connected to the input connector; and a second plate connected to the output connector. The integrator input terminal is connected to the output connector. The integrator output terminal is connected to both: i) the amplifier second input terminal; and ii) the offset measurement connector. The amplifier first input terminal is connected to the input connector. The amplifier output terminal is connected to the second plate of the capacitor. Such a voltage probe can automatically offset a DC voltage that is measured from a voltage rail while simultaneously indicating the amount of offset. Therefore, a measurement of average DC and maximum gain of high frequency components of the voltage on the voltage rail can be measured at the same time.

Figure 2

## Description

### Field

The present disclosure relates to voltage probes, and in particular to voltage probes for measuring the voltage on a voltage rail.

### Summary

According to a first aspect of the present disclosure there is provided a voltage probe comprising:

> an input connector, for connecting to a voltage rail that is to be probed;
> an output connector, for connecting to an oscilloscope to measure an AC component of a voltage on the voltage rail;
> an offset measurement connector for providing a voltage that represents a DC offset voltage on the voltage rail;
> a capacitor having a first plate and a second plate, wherein: the first plate is connected to the input connector; and the second plate is connected to the output connector;
> an integrator that has:
>
> > an integrator input terminal; and
> > an integrator output terminal;
>
> an amplifier that has an amplifier first input terminal, an amplifier second input terminal and an amplifier output terminal;
> wherein:
>
> > the integrator input terminal is connected to the output connector;
> > the integrator output terminal is connected to both: i) the amplifier second input terminal; and ii) the offset measurement connector;
> > the amplifier first input terminal is connected to the input connector; and
> > the amplifier output terminal is connected to the second plate of the capacitor.

Advantageously, such a voltage probe can automatically offset a DC voltage that is measured from the voltage rail while simultaneously indicating the amount of offset. Therefore, a measurement of average DC and maximum gain of high frequency components of the voltage on the voltage rail can be measured at the same time.

In one or more embodiments, the voltage probe further comprises a resistive divider, which comprises a first resistor and a second resistor, wherein:

> the first resistor is connected between the input connector and the amplifier first input terminal; and
> the second resistor is connected between the amplifier first input terminal and a ground terminal.

In one or more embodiments, the voltage probe further comprises an amplifier that is connected in series between the integrator output terminal and the offset measurement connector, such that it is configured to apply a gain factor to an integrator output signal provided by the integrator.

In one or more embodiments, the integrator is an analogue integrator.

In one or more embodiments, the analogue integrator comprises:

> an integrator first input terminal that is connected to the output connector; and
> an integrator second input terminal that is connected to a ground terminal.

In one or more embodiments, the integrator is a digital integrator.

In one or more embodiments, the digital integrator comprises:

> an analogue to digital converter, which has an input terminal and an output terminal;
> a processor, which has an input terminal and an output terminal; and
> a digital to analogue converter, which has an input terminal and an output terminal.

The input terminal of the analogue to digital converter may be connected to the output connector. The output terminal of the analogue to digital converter may be connected to the input terminal of the processor. The output terminal of the processor may be connected to the input terminal of the digital to analogue converter. The output terminal of the digital to analogue converter may be connected to both: i) the amplifier second input terminal; and ii) the offset measurement connector. The processor may be configured to perform voltage nulling integration on signalling received at its input terminal in order to provide signalling at its output terminal.

In one or more embodiments, the voltage probe further comprises a resistor in series between the amplifier output terminal and the second plate of the capacitor.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows a voltage probe that requires manual offset control to reduce the DC voltage that is presented to an oscilloscope for measurement;
Figure 2 shows an example embodiment of a voltage probe according to the present disclosure;
Figure 3 shows another example embodiment of a voltage probe according to the present disclosure; and
Figure 4 shows a yet further example embodiment of a voltage probe according to the present disclosure.

## Detailed Description

Voltage Rail Probes (VRPs) are used to take measurements of high speed signals and noise superimposed on DC power rails.

Examples described herein relate to a technique for accomplishing optimal measurement range of high frequency signals on a voltage rail, while automatically maintaining offset of the average voltage. The examples can also provide an accurate indication of that offset voltage, in real time, even if the average voltage drifts over time.

Examples disclosed herein improve the ability of a voltage rail probe to provide signals that have relatively low amplitude and a high frequency signals for measurement by an oscilloscope. The signals for measurement can be improved by accurately offsetting a DC average voltage. In this way, the oscilloscope gain around the desired AC signals can be optimized, without allowing the DC level to overdrive the input of the oscilloscope.

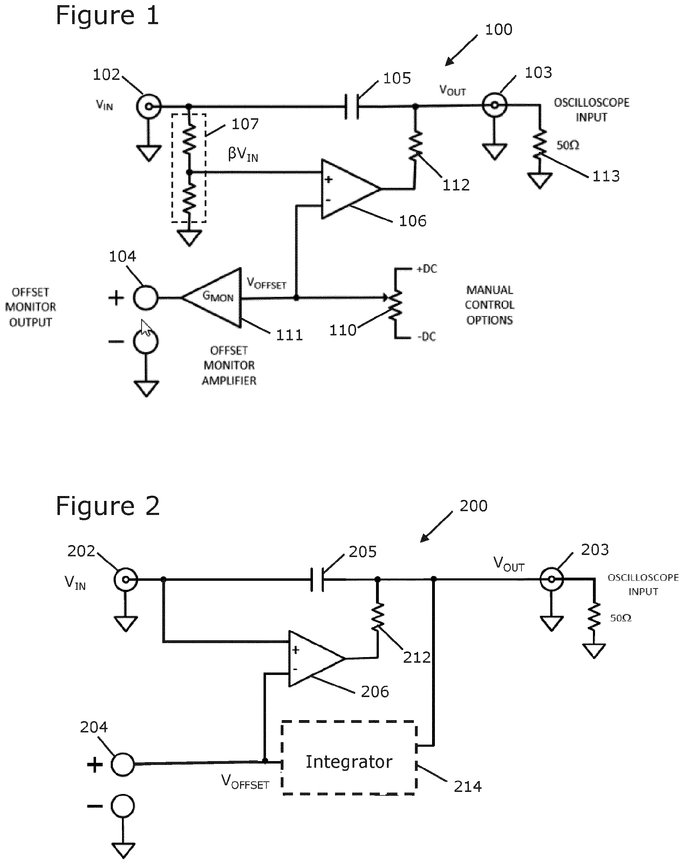

Figure 1 shows a voltage probe 100 that requires manual offset control to reduce, and potentially eliminate, the DC voltage that is presented to an oscilloscope for measuring an AC component of a voltage on a voltage rail.

The voltage probe 100 includes an input connector 102 and an output connector 103. The input connector 102 is for connecting to a voltage rail (not shown) that is to be probed. The output connector 103 is for connecting to an oscilloscope to measure an AC component of a voltage on the voltage rail. The oscilloscope is schematically illustrated in Figure 1 as a termination resistance 113. The voltage probe 100 also has an offset measurement connector 104, which provides a voltage that represents a DC offset voltage that is being applied by the voltage probe 100 with the intention of offsetting the DC voltage on the voltage rail.

The voltage probe 100 includes a capacitor 105 connected in series between the input connector 103 and the output connector 104. The capacitor 105 prevents a DC current from flowing directly from the input connector 102 to the output connector 103.

The voltage probe 100 also includes an amplifier 106. The amplifier 106 has a first input terminal (the positive input terminal in this example), a second input terminal (the negative input terminal in this example) and an output terminal. The amplifier 106 amplifies the difference between input signalling received at the first input terminal and the second input terminal in order to provide output signalling at the output terminal. The output terminal is connected to the output connector 103 via an amplifier output resistor 112. Since the intention is for the DC voltage at the output connector 103 to be zero (so that any low amplitude AC voltages can be measured more accurately by the oscilloscope connected to the output connector 103), the output of the amplifier 106 should also be zero. In order for the output of the amplifier 106 to be zero, the voltage at the two input terminals of the amplifier 106 should be equal to each other.

The voltage at the first input terminal of the amplifier 106 is based on the voltage at the input connector 102. In Figure 1, a resistive divider 107 is used to tap off a proportion of the voltage at the input connector 102, and provide that proportion of the voltage as an input voltage at the first input terminal of the amplifier 106. In Figure 1, the resistance values of the resistors in the resistive divider 107 are set such that the proportion of the input voltage that is presented to the first input terminal of the amplifier is $\beta$. Therefore, the voltage at the first input terminal of the amplifier 106 can be represented as $\beta \cdot V_{IN}$, when $V_{IN}$ is the voltage at the input connector 102.

The voltage probe 100 also has a manual control, which is represented in Figure 1 as a potentiometer 110. A user can set the position of the sliding contact of the potentiometer 110 in order to adjust the voltage that is presented to the second input terminal of the amplifier 106. The user can therefore adjust the position of the sliding contact until the DC voltage at the output connector 103 (as measured by the oscilloscope) is zero, or considered close enough to zero to be able to accurately measure a lower amplitude AC voltage signal.

The sliding contact of the potentiometer 110 is also connected to the offset measurement connector 104. In this way, the DC voltage at the offset measurement connector 104 represents the user's manual control of the potentiometer 110. A meter or oscilloscope can be connected to the offset measurement connector 104 to measure the DC voltage at the offset measurement connector 104. In this example, an amplifier 111 is connected in series between the sliding contact of the potentiometer 110 and the offset measurement connector 104. The amplifier applies a gain factor, $G_{MON}$, such that the voltage at the offset measurement connector 104 ($V_{MON}$) is larger or smaller than the voltage at the sliding contact of the potentiometer 110 ($V_{OFFSET}$). That is, the offset monitor output voltage, $V_{MON}$, can be represented as:

$$V_{MON} = \beta \times V_{IN} \times G_{MON}.$$

When the manual offset control of Figure 1 is used, the voltage at the output connector 103 of the voltage rail probe 100 may not be exactly at zero volts. In which case the offset monitor output voltage, $V_{MON}$, will indicate the amount of DC offset being applied by the manually operated potentiometer 110 only. Therefore, such rail probes must be manually adjusted to achieve the proper nulling of the voltage at the output connector 103. Also, as the voltage on the voltage rail changes, and therefore so does the voltage at the input connector 102, the manual offset being applied must be continuously adjusted in order to maintain the voltage null at the output connector 103 of the voltage probe 100.

Figure 2 shows an example embodiment of a voltage probe 200 according to the present disclosure. Features of Figure 2 that are also shown in Figure 1 are given corresponding reference numbers in the 200 series, and will not necessarily be described in detail again here. As will be discussed in detail below, the voltage probe 200 of Figure 2 does not require the manual control of Figure 1. Instead, the voltage probe 200 of Figure 2 can automatically determine a DC offset voltage that is required to cancel out the DC voltage on the voltage rail.

The rail probe of Figure 2 includes an input connector 202 and an output connector 203. In the same way as described above, the input connector 202 is for connecting to a voltage rail (not shown) and the output connector 103 is for connecting to an oscilloscope to measure an AC component of a voltage on the voltage rail. The voltage probe 200 includes an offset measurement connector 204 for providing a voltage that represents a DC offset voltage on the voltage rail.

The voltage probe 200 includes a capacitor 205, which has a first plate and a second plate. The first plate is connected to the input connector 202. The second plate is connected to the output connector 203.

The voltage probe 200 also has an integrator 214. As will be discussed below, the integrator 214 can provide the functionality of a highly accurate automatic-zero circuit, which continuously servos the voltage at the output connector 203 to zero.

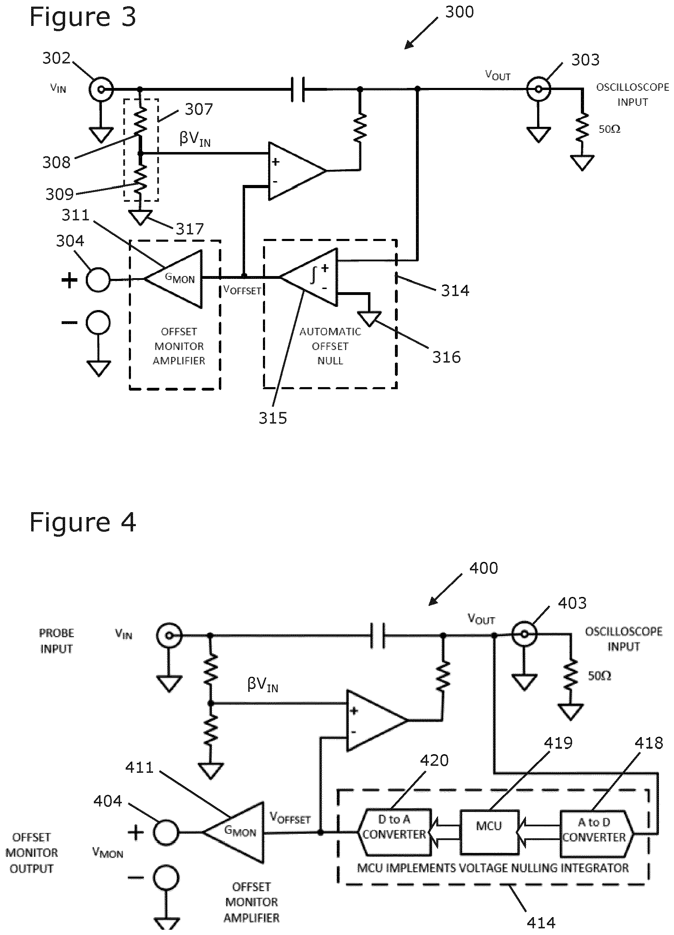

The integrator 214 has an integrator input terminal and an integrator output terminal. The integrator input terminal is connected to the output connector 203 such that it receives the voltage at the output connector 203 as an input signal. This input signal is shown in Figure 2 as $V_{OUT}$. This signal can be referred to as an integrator input signal The integrator output terminal provides an integrator output signal, which is shown in Figure 2 as $V_{OFFSET}$. The integrator 214 is configured to provide the integrator output signal as a time integral of the integrator input signal with respect to ground. As will be illustrated with reference to Figures 3 and 4, the integrator 214 can be provided as an analogue or a digital implementation.

In the same way as Figure 1, the amplifier 206 of Figure 2 has an amplifier first input terminal (the positive input terminal in Figure 2), an amplifier second input terminal (the negative input terminal in Figure 2) and an amplifier output terminal. A resistor 212 is connected in series between the amplifier output terminal and the second plate of the capacitor 205.

The integrator output terminal is connected to both: i) the amplifier second input terminal; and ii) the offset measurement connector 204. The amplifier first input terminal is connected to the input connector 202. The amplifier output terminal is connected to the second plate of the capacitor 205, and therefore in this example it is also directly connected to the output connector 203.

In Figure 2, advantageously the integrator 214 is placed inside a control loop which automatically servos the voltage at the output connector 203 of the voltage probe 200 to zero. That is, a control loop is provided by the amplifier 206 and the integrator 214 such that the integrator 214 automatically adjusts its output signal ($V_{OFFSET}$) until its input signal ($V_{OUT}$) is zero.

Furthermore, since the output signal ($V_{OFFSET}$) of the integrator 214 is controller such that it is equal to the voltage ($V_{IN}$) at the input connector 202, connecting the integrator output terminal directly to the offset measurement connector 204 enables the magnitude of the DC offset to be readily measured by connecting a meter to the offset measurement connector 204.

Figure 3 shows another example embodiment of a voltage probe 300 according to the present disclosure. Features of Figure 3 that are also shown in an earlier figure are given corresponding reference numbers in the 300 series, and will not necessarily be described in detail again here. In this example, an analogue implementation of the integrator 314 of Figure 2 is shown.

The analogue integrator 314 comprises an integrator amplifier 315, which has an integrator first input terminal and an integrator second input terminal. The integrator first input terminal is connected to the output connector 303 in the same way as the integrator input terminal of Figure 2. The integrator second input terminal that is connectable to a ground terminal 316.

The voltage probe 300 of Figure 3 also includes a resistive divider 307, which includes a first resistor 308 and a second resistor 309. The first resistor 308 is connected between the input connector 302 and the amplifier first input terminal. The second resistor 309 is connected between the amplifier first input terminal and a ground terminal 317. In this way, the ratio of the resistance values of the first resistor 308 and the second resistor 309 will define what proportion of the voltage at the input connector ($V_{IN}$) is presented to the amplifier first input terminal. The divide ratio of the resistors in Figure 3 is identified as $\beta$, such that the voltage at the amplifier first input ter-

minal is $\beta V_{IN}$.

In Figure 3, the voltage probe 300 also includes an amplifier 311 that is connected in series between the integrator output terminal and the offset measurement connector 304, such that it is configured to apply a gain factor to the integrator output signal ($V_{OFFSET}$). This gain factor is identified as $G_{MON}$ in Figure 3.

Therefore, the voltage probe 300 of Figure 3 can monitor the DC offset voltage on the voltage rail using the output of the integrator 314, $V_{OFFSET}$. This is because the integrator output will be a scaled representation of the DC input voltage when the loop is closed (the output voltage is nulled to zero). Also, because $V_{OUT} = 0$, $V_{OFFSET} = \beta V_{IN}$ which is an exact representation of the input voltage. The use of the resistive divider 307 provides a fixed attenuation of $\beta$, which can be beneficial if the input voltage is higher than the range of the amplifiers.

If $\beta$ is chosen to be something convenient, such as 1 or 0.1, then the voltage at the offset measurement connector 304 ($V_{MON}$) is easy to interpret because it will be easily mapped to the probe input voltage ($V_{IN}$). For example, if the desired scale $\dfrac{V_{MON}}{V_{IN}}$ is chosen to be 0.1, then the $V_{MON}$ output will be exactly 1/10 the probe input voltage $V_{IN}$.

The integrator 314 of Figure 3 contributes to the functionality of an automatic-zero circuit. In this example, the integrator amplifier 315 is implemented as a precise differential amplifier. The inputs of the integrator amplifier 315 / integrator 314 are connected to the output connector of the voltage rail probe (VRP) and to GROUND, respectively. An integrator function is used so that the loop only responds to the average voltage level; it is unaffected by high frequency components.

Figure 4 shows a yet further example embodiment of a voltage probe 400 according to the present disclosure. The voltage probe 400 of Figure 4 is similar to the one of Figure 3, but in Figure 4 a digital implementation of the integrator 414 is shown.

The digital integrator 414 of Figure 4 includes an analogue to digital converter (ADC), a microcontroller 419 (or a similar processor) and a digital to analogue converter (DAC).

The ADC 418 has an input terminal and an output terminal. The microcontroller 419 has an input terminal and an output terminal. The DAC 420 also has an input terminal and an output terminal. These three components are connected together in series, in that order, between the output connector 403 and the amplifier second input terminal. That is:

- the input terminal of the ADC 418 is connected to the output connector 403;
- the output terminal of the ADC 418 is connected to the input terminal of the microcontroller 419;

- the output terminal of the microcontroller 419 is connected to the input terminal of the DAC 420; and
- the output terminal of the DAC 420 is connected to the amplifier second input terminal.

In addition, in the same way as Figure 3, the output terminal of the DAC 420 is also connected to the offset measurement connector 404 (in this example via an amplifier 411).

The microcontroller 419 performs voltage nulling integration on signalling received at its input terminal in order to provide signalling at its output terminal. Therefore, the microcontroller 419 performs digital integration on a digital representation of the output voltage ($V_{OUT}$) in order to provide a digital representation of the DC offset voltage ($V_{OFFSET}$).

In this way, a digitally controlled nulling loop can be implemented that includes a digital integrator 414 for performing the voltage measurement (ADC input), the integration function, and the offset output voltage (DAC output).

Any of the integrators described herein can be relatively high gain, in order to provide sufficiently accurate offset compensation and measurement. For example, an integrator dc gain of 10^5 or greater is easily achieved with common precision amplifiers and/or high resolution data converters.

One or more of the voltage probes described herein can improve on known voltage rail probe designs by adding two key elements:

1. A highly accurate automatic-zero circuit, which continuously / periodically servos the output voltage to zero.
2. A monitor output, which uses the automatic-zero circuit's control voltage to indicate the precise amount of voltage that is being offset. This voltage accurately matches the average voltage at the input of the probe.

Therefore, when the auto-zero method is being used, the voltage at the offset measurement connector can indicate the average voltage at the input of the rail probe exactly.

Advantageously, the probes described herein can automatically offset the DC voltage while simultaneously indicating the amount of offset such that a measurement of average DC and maximum gain of the high frequency components can be measured at the same time. This is beneficial when compared with a manual offset of the DC average level. Therefore, if the average voltage drifts then it is not necessary to manually change the offset in real time. Furthermore, the dynamic range for measuring the high frequency signals at the output connector of the voltage probe can be optimized.

The voltage probes described herein can be used for testing power voltage rails in any type of equipment where the high frequency content should be measured by offsetting the DC average voltage, while preserving the average DC voltage information and simultaneously offsetting the signal to zero. In this way, sensitive equipment can be used to measure the small high frequency signals without being over-driven by a DC offset voltage.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A voltage probe comprising:

    an input connector, for connecting to a voltage rail that is to be probed;
    an output connector, for connecting to an oscilloscope to measure an AC component of a voltage on the voltage rail;
    an offset measurement connector for providing a voltage that represents a DC offset voltage on the voltage rail;
    a capacitor having a first plate and a second plate, wherein: the first plate is connected to the input connector; and the second plate is connected to the output connector;
    an integrator that has:

        an integrator input terminal; and
        an integrator output terminal;

    an amplifier that has an amplifier first input terminal, an amplifier second input terminal and an amplifier output terminal;
    wherein:

        the integrator input terminal is connected to the output connector;
        the integrator output terminal is connected to both: i) the amplifier second input terminal; and ii) the offset measurement connector;
        the amplifier first input terminal is connected to the input connector; and
        the amplifier output terminal is connected to the second plate of the capacitor.

2. The voltage probe of claim 1, further comprising a resistive divider, which comprises a first resistor and a second resistor, wherein:

    the first resistor is connected between the input connector and the amplifier first input terminal; and

the second resistor is connected between the amplifier first input terminal and a ground terminal.

3. The voltage probe of claim 1 or claim 2, further comprising an amplifier that is connected in series between the integrator output terminal and the offset measurement connector, such that it is configured to apply a gain factor to an integrator output signal provided by the integrator.

4. The voltage probe of any preceding claim wherein the integrator is an analogue integrator.

5. The voltage probe of claim 4, wherein the analogue integrator comprises:

   an integrator first input terminal that is connected to the output connector; and
   an integrator second input terminal that is connectable to a ground terminal.

6. The voltage probe of any one of claims 1 to 3, wherein the integrator is a digital integrator.

7. The voltage probe of claim 6, wherein the digital integrator comprises:

   an analogue to digital converter, which has an input terminal and an output terminal;
   a processor, which has an input terminal and an output terminal; and
   a digital to analogue converter, which has an input terminal and an output terminal;

   wherein:

   the input terminal of the analogue to digital converter is connected to the output connector;
   the output terminal of the analogue to digital converter is connected to the input terminal of the processor;
   the output terminal of the processor is connected to the input terminal of the digital to analogue converter;
   the output terminal of the digital to analogue converter is connected to both: i) the amplifier second input terminal; and ii) the offset measurement connector; and
   the processor is configured to perform voltage nulling integration on signalling received at its input terminal in order to provide signalling at its output terminal.

8. The voltage probe of any preceding claim, further comprising a resistor in series between the amplifier output terminal and the second plate of the capacitor.

# Figure 1

# Figure 2

# Figure 3

# Figure 4

Europäisches
Patentamt

European
Patent Office

Office européen
des brevets

## EUROPEAN SEARCH REPORT

Application Number

**EP 23 17 7017**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 105 116 362 A (UNIV ELECTRONIC SCIENCE & TECH) 2 December 2015 (2015-12-02) | 1,2,4-8 | INV. G01R1/067 G01R19/00 |
| Y | * the whole document * | 3 | |
| Y | US 2020/132731 A1 (MENDE MICHAEL J [US]) 30 April 2020 (2020-04-30) * paragraph [0037]; figures 4-5 * | 3 | ADD. G01R15/09 |

TECHNICAL FIELDS
SEARCHED      (IPC)

**G01R**

The present search report has been drawn up for all claims

| Place of search | Date of completion of the search | Examiner |
|---|---|---|
| **The Hague** | **29 November 2023** | **Mazagão Guerreiro, R** |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

  .........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 7017

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2023

| Patent document cited in search report | | Publication date | Patent family member(s) | | Publication date |
|---|---|---|---|---|---|
| CN 105116362 | A | 02-12-2015 | NONE | | |
| US 2020132731 | A1 | 30-04-2020 | CN | 111051895 A | 21-04-2020 |
| | | | DE | 112018003599 T5 | 16-04-2020 |
| | | | JP | 7357600 B2 | 06-10-2023 |
| | | | JP | 2020527708 A | 10-09-2020 |
| | | | KR | 20200028963 A | 17-03-2020 |
| | | | US | 2020132731 A1 | 30-04-2020 |
| | | | US | 2023266369 A1 | 24-08-2023 |
| | | | WO | 2019014622 A1 | 17-01-2019 |

EPO FORM P0459

For more details about this annex : see Official Journal of the European Patent Office, No. 12/82